(19) Europäisches Patentamt European Patent Office Office européen des brevets

(11) **EP 4 524 593 A1**

(12) **EUROPEAN PATENT APPLICATION**
published in accordance with Art. 153(4) EPC

(43) Date of publication:
**19.03.2025 Bulletin 2025/12**

(21) Application number: **23811802.0**

(22) Date of filing: **23.05.2023**

(51) International Patent Classification (IPC):
**G01R 33/12** (2006.01)

(52) Cooperative Patent Classification (CPC):
**G01R 33/12**

(86) International application number:
**PCT/JP2023/019074**

(87) International publication number:
**WO 2023/228930 (30.11.2023 Gazette 2023/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **27.05.2022 JP 2022086896**

(71) Applicant: **Tohoku University Sendai-shi, Miyagi 980-8577 (JP)**

(72) Inventors:
• YABUKAMI, Shin
  **Sendai-shi, Miyagi 980-8577 (JP)**
• OKITA, Kazuhiko
  **Sendai-shi, Miyagi 980-8577 (JP)**
• WATANABE, Yoshiyuki
  **Sendai-shi, Miyagi 980-8577 (JP)**

(74) Representative: **FDST Patentanwälte Nordostpark 16 90411 Nürnberg (DE)**

(54) **MAGNETIC PERMEABILITY MEASUREMENT PROBE AND MAGNETIC PERMEABILITY MEASUREMENT DEVICE USING SAME**

(57) The probe for measuring a magnetic permeability of a magnetic material includes: a transmission line body including a strip-shaped strip conductor formed on a front surface of a dielectric substrate and a ground conductor formed on the front surface or a back surface of the dielectric substrate; a first connector connected to one end of each of the strip conductor and the ground conductor; and a second connector connected to the other end of each of the strip conductor and the ground conductor, in which the strip conductor includes a first length portion including a portion connected to the first connector on one end side, a second length portion including a portion connected to the second connector at the other end, and a third length portion extending between the first length portion and the second length portion, and the third length portion includes a current deviation prevention unit.

[FIG. 2]

**Description**

TECHNICAL FIELD

The present invention relates to a probe for measuring a magnetic permeability of a magnetic material and a magnetic permeability measurement device using the same.

BACKGROUND ART

Currently, high-frequency applications using a GHz band such as a mobile phone or wireless communication have become popular. There is a strong demand for high-frequency magnetic materials that can be used to further miniaturize and integrate components of these high-frequency applications, and in particular, a magnetic film having a high magnetic permeability is essential for a magnetic material used in a circuit. Simultaneously, establishment of a high-frequency magnetic permeability evaluation method is essential.

Inventors of the application have developed a magnetic permeability measurement device that does not require hard task such as processing of a sample. Each of PTLs 1 to 4 discloses a probe for measuring a magnetic permeability of a magnetic material, particularly a film-like magnetic material, and a magnetic permeability measurement device, which have been developed by the inventors. Each of the probes has a structure in which a dielectric layer is sandwiched between a strip conductor to which a high-frequency carrier signal is energized and a ground conductor, and the magnetic material to be measured is brought into contact with the conductors, and a permeability coefficient $S_{21}$ of the magnetic material to be measured is measured to obtain the magnetic permeability of the magnetic material.

The obtained magnetic permeability is a complex magnetic permeability $\mu$ represented by the following Equation (1), where $\mu'$ is a real part of the complex magnetic permeability $\mu$, and $\mu''$ is an imaginary part of the complex magnetic permeability $\mu$.
[Math. 1]

$$\mu = \mu' - j\mu'' \qquad (1)$$

The real part $\mu'$ of the complex magnetic permeability $\mu$ corresponds to an inductance component L of the magnetic material, and the imaginary part $\mu''$ of the complex magnetic permeability $\mu$ corresponds to a loss (resistance component) of the magnetic material.

CITATION LIST

PATENT LITERATURE

PTL 1: JP2010-060367A
PTL 2: JP2012-032165A
PTL 3: JP2015-172497A
PTL 4: JP2016-053569A

SUMMARY OF INVENTION

PROBLEMS TO BE SOLVED BY THE INVENTION

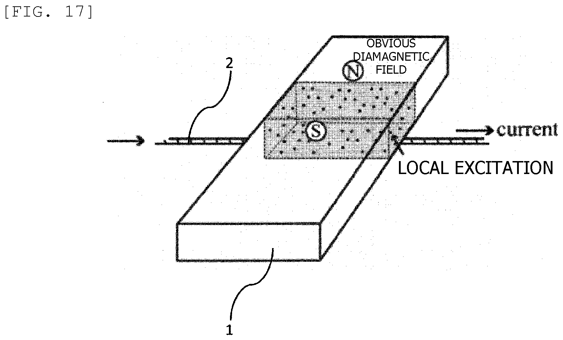

FIG. 17 is a diagram schematically showing a magnetic field region excited in a magnetic material to be measured, in particular, a magnetic material having an area larger than a width of a strip conductor. Although a magnetic material 1 to be measured is excited by a high-frequency carrier signal (current) flowing through a strip conductor 2 of a probe in contact with the magnetic material 1, according to electromagnetic field analysis performed by the inventors of the application, it has been found that when the strip conductor 2 is relatively thin and a width of the strip conductor 2 is relatively small with respect to the width of the magnetic material 1, the whole of the magnetic material 1 is not excited, and only a local region in the vicinity of a contact region with the strip conductor 2 is excited, so that a measurement error of magnetic permeability is generated.

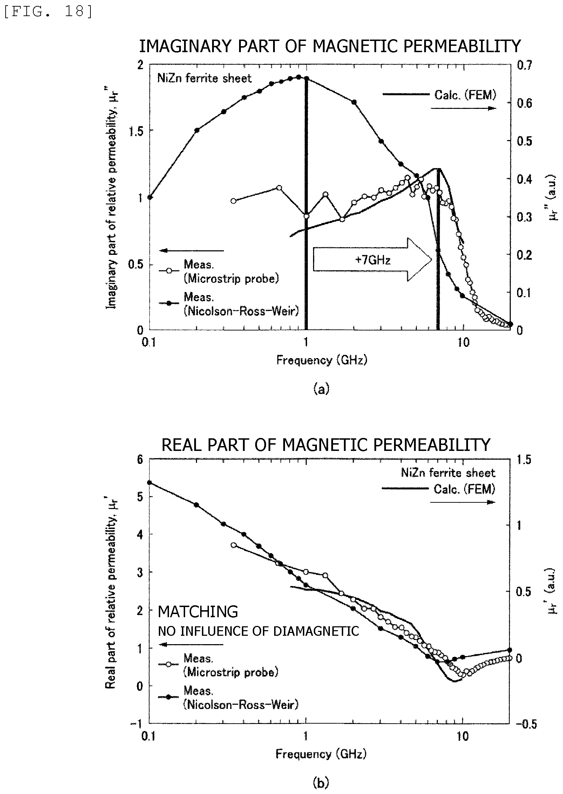

When the magnetic material is locally excited, a diamagnetic field is generated outside the locally generated magnetic field inside the magnetic material, and therefore, the influence of the diamagnetic field is to cancel out the magnetic flux of the excited magnetic field, which causes an error in the actual magnetic permeability of the magnetic material to be measured. More specifically, there may be a case where a resonance frequency in the imaginary part $\mu''$ of the complex magnetic permeability $\mu$ in the above Equation (1) is deviated, and the magnetic permeability cannot be measured with high accuracy. FIG. 18 is a graph showing a measurement example in which an error occurs in the imaginary part of the magnetic permeability due to the influence of the demagnetization field. The graph shows measurement values obtained using a probe equipped with a microstrip line of an elongated conductor and measurement values obtained using the Nicolson-Ross-Weir (NRW) method, which is a standard magnetic permeability measurement method that is not influenced by the diamagnetic field, in which (a) of FIG. 18 shows the value of the imaginary part $\mu''$ of the complex magnetic permeability $\mu$, and (b) of FIG. 18 shows the value of the real part $\mu'$ of the complex magnetic permeability $\mu$. The magnetic material to be measured is a NiZn ferrite thin film (3 mm × 1 mm × thickness 100 $\mu$m), and as shown in (a) of FIG. 18, on the basis of the measurement values according to the NRW method, the resonance frequency in the imaginary part $\mu''$ of the complex magnetic permeability $\mu$ is deviated to the high frequency side by 7 GHz, and a large error occurs in the measurement values. Note that the measurement value of the real part $\mu'$ of the complex magnetic permeability $\mu$ shown in (b) of FIG. 18 appears to be roughly in line with the measurement value obtained by the NRW method, but change points should have moved to the high frequency side in the same way, and it may be difficult to observe the change points since they are buried in noise.

Magnetic permeability evaluation of a film-like magnetic material, which is a sample to be measured, is often performed using a standard measurement method, such as the NRW method, but it requires the sample to be precisely machined into a doughnut shape and to be precisely positioned in a coaxial tube, which is technically difficult and time-consuming. On the other hand, when the evaluation is performed by using a signal transmission line such as a microstrip line having a strip conductor, as described above, when the magnetic material having an area larger than the width of the strip conductor is measured, a local magnetic field application is stronger in the diamagnetic field of the magnetic material, shift of a ferromagnetic resonance frequency, a decrease in the magnetic permeability and the like occur, and it is difficult to accurately measure the magnetic permeability specific to the material.

The inventors of the application have attempted measurement after expanding the width of the strip conductor, increasing a distance between the strip conductor and the sample, or the likes, but neither of them worked. Especially, when the width of the strip conductor was expanded, deviation of the current toward a conductor width direction (outer periphery) due to a skin effect was generated, and the measurement was not successfully performed.

Therefore, an object of the invention is to provide a magnetic permeability measurement probe and a magnetic permeability measurement device using the same capable of measuring a magnetic permeability with high accuracy even of a magnetic material having an area larger than a width of a strip conductor.

MEANS FOR SOLVING THE PROBLEMS

A magnetic permeability measurement probe according to the invention for achieving the above object is a probe for measuring a magnetic permeability of a magnetic material, the probe including: a transmission line body including a strip-shaped strip conductor formed on a front surface of a dielectric substrate and a ground conductor formed on the front surface or a back surface of the dielectric substrate; a first connector connected to one end of each of the strip conductor and the ground conductor; and a second connector connected to the other end of each of the strip conductor and the ground conductor, in which the strip conductor includes a first length portion including a portion connected to the first connector on one end side, a second length portion including a portion connected to the second connector at the other end, and a third length portion extending between the first length portion and the second length portion, and the third length portion includes a current deviation prevention unit.

ADVANTAGEOUS EFFECTS OF THE INVENTION

According to the invention, by providing the current deviation prevention unit in the strip conductor of the transmission line body, it is possible to prevent the deviation of the current toward the conductor width direction due to the skin effect and to reduce the influence of the diamagnetic field, and thus it is possible to measure the magnetic permeability (in particular, the imaginary part of the complex magnetic permeability) of the magnetic material with high accuracy.

BRIEF DESCRIPTION OF DRAWINGS

    [FIG. 1] FIG. 1 is a diagram showing a schematic configuration example of a magnetic permeability measurement device according to an embodiment of the invention.
    [FIG. 2] FIG. 2 is a diagram showing a first configuration example of a probe according to a first embodiment of the invention.
    [FIG. 3] FIG. 3 is a diagram showing a pattern of a strip conductor constituting the probe.
    [FIG. 4] FIG. 4 is a diagram schematically showing a magnetic field region excited in a magnetic material 1 to be measured by a strip conductor 11 having a large width provided with a slit 17 according to the first embodiment of the invention.
    [FIG. 5] FIG. 5 is a diagram showing a modification of the pattern of the strip conductor in the probe.
    [FIG. 6] FIG. 6 is a diagram showing a second configuration example of the probe according to the first embodiment of the invention.
    [FIG. 7] FIG. 7 is a diagram showing a strip conductor according to a second embodiment of the invention.
    [FIG. 8] FIG. 8 is a diagram showing a strip conductor according to a third embodiment of the invention.
    [FIG. 9] FIG. 9 is a diagram showing a strip conductor according to a fourth embodiment of the invention.
    [FIG. 10] FIG. 10 is a diagram showing a strip conductor according to a fifth embodiment of the invention.
    [FIG. 11] FIG. 11 is a flowchart showing a procedure of a magnetic permeability measurement method according to the embodiment of the invention.
    [FIG. 12] FIG. 12 is a diagram schematically showing a shape of a magnetic film as the magnetic material to be measured.
    [FIG. 13] FIG. 13 is a graph of a measurement result of a magnetic permeability measured by the magnetic permeability measurement device using the probe according to the embodiment of the invention.
    [FIG. 14] FIG. 14 is a diagram showing a modification of the strip conductor 11 constituting the probe according to the first embodiment of the invention.
[FIG. 15] FIG. 15 is a diagram showing the other modification of the strip conductor 11 constituting the probe according to the first embodiment of the invention.
[FIG. 16] FIG. 16 is a diagram showing a measurement result of a current density flowing through the strip conductor 11.
[FIG. 17] FIG. 17 is a diagram schematically showing a magnetic field region excited in a magnetic material to be measured when a probe in the related art is used.
[FIG. 18] FIG. 18 is a graph showing a measurement example in which an error occurs in an imaginary part of the magnetic permeability due to influence of a diamagnetic field.

DESCRIPTION OF EMBODIMENTS

Hereinafter, embodiments of the invention will be described with reference to the drawings. However, the embodiments do not limit the technical scope of the invention.

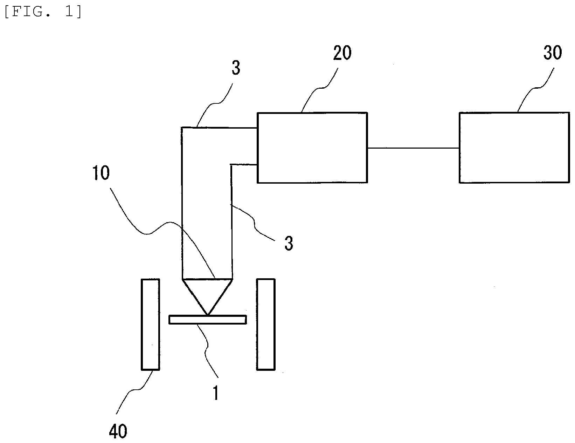

FIG. 1 is a diagram showing a schematic configuration example of a magnetic permeability measurement device according to an embodiment of the invention. The magnetic permeability measurement device according to the embodiment of the invention includes a probe 10, a network analyzer (signal meter) 20, and an arithmetic processing device (for example, a computer device such as a personal computer) 30 (processing unit) for executing numerical value analysis processing.

A magnetic material 1 to be measured is, for example, a film-like magnetic material having a film thickness of approximately 100 $\mu$m. The probe 10 is disposed so as to be in contact or close to the magnetic material 1, and is connected to the network analyzer 20 via a nonmagnetic coaxial cable 3. A permeability coefficient $S_{21}$ of the magnetic material 1 to be measured is measured by the network analyzer 20, signal data thereof is taken into a control personal computer 30, and a complex magnetic permeability of the magnetic material is acquired by predetermined numerical value analysis processing (for example, optimization processing). In order to magnetically saturate the magnetic material 1, for example, a magnet (magnetic field application unit) made of a double yoke type electromagnet 40 is used.

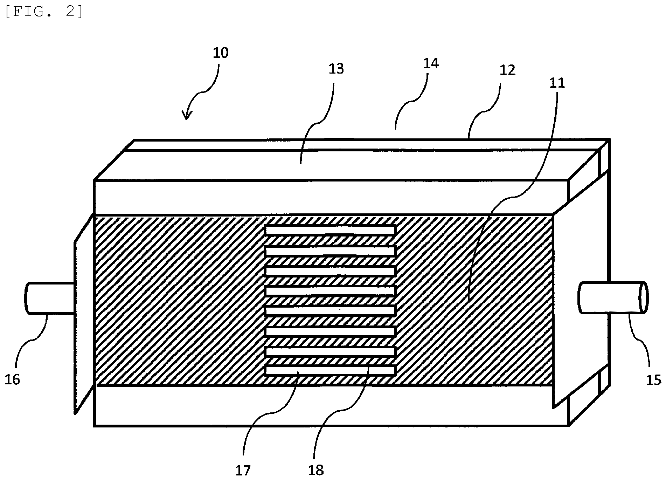

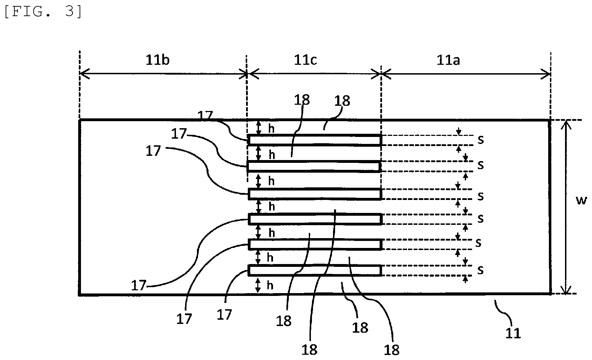

FIG. 2 is a diagram showing a first configuration example of the probe according to the first embodiment of the invention, and FIG. 3 is a diagram showing a pattern of a strip conductor constituting the probe.

The probe 10 includes a transmission line body 14 constituting a microstrip line having a structure in which a dielectric substrate 13 is sandwiched between a strip conductor 11 and a ground conductor 12, and connectors 15 and 16 electrically connected to both ends of the transmission line body 14 in the length direction, respectively. The transmission line body 14 includes the dielectric substrate 13, the strip-shaped strip conductor 11 formed on a front surface of the dielectric substrate 13, and the ground conductor 12 formed on a back surface of the dielectric substrate 13. The coaxial cable 3 of 50 $\Omega$ is connected to the connectors 15 and 16, and is connected to the network analyzer 20. The transmission line body 14 is manufactured by, for example, etching a printed circuit board made of a fluororesin (for example, polytetrafluoroethylene (PTFE)).

The strip conductor 11 includes a first length portion 11a including a portion connected to the connector 15 at one end side in the length direction, a second length portion 11b including a portion connected to the connector 16 at the other end in the length direction, and a third length portion 11c extending between the first length portion 11a and the second length portion 11b, and the third length portion 11c has at least one slit 17 extending along the length direction.

The strip conductor 11 is formed to have a relatively large width (for example, 1.2 mm in width) in accordance with a width direction length of the magnetic material 1 to be measured, and is designed to have a dimension equal to or larger than the width direction length of the magnetic material 1 to be measured. By forming the strip conductor 11 to have a relatively large width, the entire front surface of the magnetic material 1 to be measured can be brought into contact with the third length portion 11c of the strip conductor 11.

On the other hand, when the strip conductor 11 is designed to have a relatively large width, it is clear that most of a high-frequency signal (current) flowing through the strip conductor 11 flows through regions of both ends (left and right ends) in a width direction of the strip conductor 11 and hardly flows through a center portion therebetween, and therefore, in the invention, the slit 17 is provided as a current deviation prevention unit so that the high-frequency carrier signal (current) flows almost uniformly across the entire width direction of the strip conductor 11 having a large width.

The slit 17 is an elongated gap region extending in the region of the third length portion 11c along the length direction of the strip conductor 11, and by providing the slit 17, in the region of the third length portion 11c of the strip conductor 11, the one strip conductor portion having a large width can be divided into a plurality of elongated strip conductor portions 18 extending side by side, and the current can flow uniformly through each of the elongated strip conductor portions 18 divided by the slit 17. Preferably, the plurality of slits 17 are formed to extend parallel to each other in the length direction.

In consideration of a skin effect of the conductor in the high-frequency current, a width dimension h of each elongated strip conductor portion 18 through which a uniform current can flow is acquired based on a skin depth indicating the skin effect of the strip conductor 11 (the skin depth may be acquired by approximation calculation). A width dimension s and the number of the slit 17 are determined in accordance with a relation between a width dimension w of the third length portion 11c and the width dimension h of the elongated strip conductor portion 18. Within a manufacturing technique range, by decreasing the width dimension s of the slit 17, forming a greater number of the slits 17, and forming a greater number of the elongated strip conductor portions 18, current distribution in the width direction can be made more uniform in the region of the third length portion 11c of the strip conductor 11.

The width s of the slit 17 and the width h of the elongated strip conductor portion 18 of the invention are preferably approximately 0.1 μm to 100 μm, and more preferably 1 μm to 10 μm. The width of the slit 17 and the width of the elongated strip conductor portion 18 may be the same or different as described later. The narrower the slit width, the more uniform the current and excitation can be, even in a high frequency band. Examples of a preparation method thereof include known methods such as sputtering and electrodeposition (electrocoating).

In the pattern of the strip conductor 11 shown in FIGS. 2 and 3, the width dimension s of each slit 17 is the same and the slits 17 are also arranged at an equal interval, and furthermore, the width dimension h of each elongated strip conductor portion 18 is also the same and the elongated strip conductor portions 18 are also arranged at an equal interval. The width dimension h of the elongated strip conductor portion 18 corresponds to an interval dimension of the slits 17, and the width s of the slit 17 corresponds to an interval dimension of the elongated strip conductors 18.

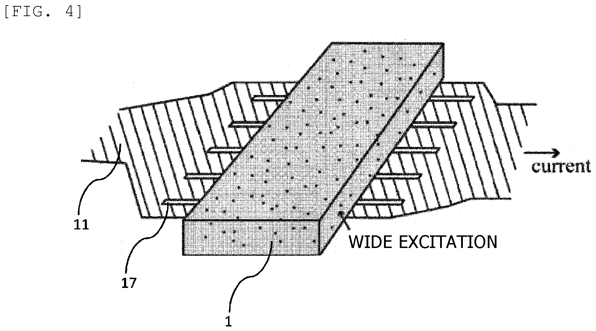

FIG. 4 is a diagram schematically showing a magnetic field region excited in the magnetic material 1 to be measured by the strip conductor 11 having a large width provided with the slit 17 according to the first embodiment of the invention. By forming the strip conductor 11 (the third length portion 11c with which the magnetic material 1 comes into contact) to be large in width to correspond to the size of the magnetic material 1 to be measured, and providing the above-mentioned slit 17, deviation of the current in a conductor width direction due to the skin effect is prevented, and a uniform current flows throughout the entire strip conductor 11 (the third length portion 11c with which the magnetic material 1 comes into contact), and therefore, the magnetic material 1 to be measured is excited entirely, not locally. As a result, even when the magnetic material 1 to be measured has a wide area, the influence of the diamagnetic field can be reduced, and the magnetic permeability of the magnetic material to be measured can be measured with high accuracy.

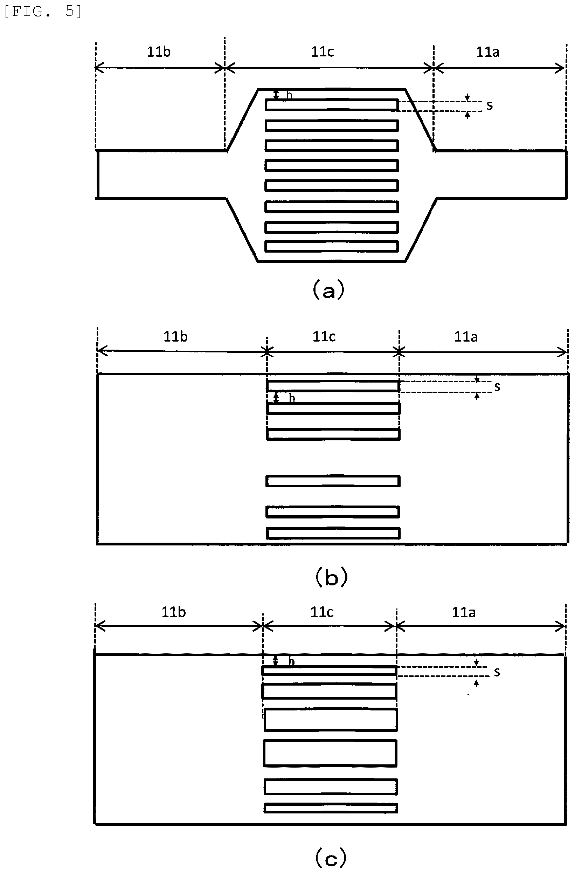

FIG. 5 is a schematic diagram showing a modification of the pattern of the strip conductor 11 in the probe. In the example shown in (a) of FIG. 5, the first length portion 11a and the second length portion 11b of the strip conductor 11 have narrower dimensions in width than the third length portion 11c, and the first length portion 11a and the second length portion 11b may have any width dimension that allows connection to the connectors 15 and 16, respectively. The third length portion 11c is tapered on both sides down to the width dimensions of the first length portion 11a and the second length portion 11b. In (a) of FIG. 5, an example of a pattern in which the width dimension of the third length portion 11c is tapered is shown, but a pattern in which the width dimension narrows at right angles and smoothly connected with a curve may be adopted. Note that the entire shape may be circular as long as the third length portion 11c has a larger width dimension than the first length portion 11a and the second length portion 11b.

The example shown in (b) of FIG. 5 shows a pattern in which the slits 17 are arranged at different intervals in the width direction. Specifically, the plurality of slits 17 are arranged at different intervals so that the elongated strip conductor portions 18 are arranged more coarsely from both end sides in the width direction toward a center. In this case, the width dimension h of the elongated strip conductor portion 18 increases from both end sides toward the vicinity of the center. The width dimension s of each slit 17 is the same.

As described above, in a conductor having a large width, since a relatively large current flows at both ends thereof in the width direction, and a relatively small current flows in the vicinity of a center thereof, in order to make a larger current flow in the vicinity of the center, according to the current distribution, the elongated strip conductor portions 18 are made coarser in the center portion as compared with both end sides, and the width dimension h of the elongated strip conductor portion 18 is made narrower at both end sides and wider in the center portion, so that the deviation in the current distribution can be corrected to make the current distribution more uniform.

According to simulation analysis of inventors of the application, it was clear that the current distribution decreases exponentially from both ends of the conductor having a large width toward the vicinity of the center, specifically, decreases according to 1/e (natural logarithm). Therefore, it is preferable that the width dimension h of the plurality of elongated strip conductor portions 18 separated by the slits 17 is set to be, for example, a natural logarithm "e" times larger from both end sides toward the vicinity of the center. The multiple value may be a value of 2 to 3 times close to the natural logarithm e.

The example shown in (c) of FIG. 5 shows a pattern in which the width dimension s of each slit 17 is varied in the width direction. As in (b) of FIG. 5, the width dimensions s of the plurality of slits 17 are formed to be different from each other such that the elongated strip conductor portions 18 are arranged more coarsely from both end sides in the width direction toward the center. In this case, the width dimension s of the slit 17 increases from both end sides toward the vicinity of the center. The width dimension h of each elongated strip conductor portion 18 is the same.

In the pattern example in (c) of FIG. 5, by arranging the elongated strip conductor portions 18 to be coarser in the center portion as compared with both end sides, the deviation of the current distribution can be corrected and more uniform current distribution can be obtained.

A pattern may be adopted in which the width dimension s of each slit 17 may be different from each other, and the slits 17 may be arranged to have intervals (corresponding to the width dimension h of the elongated strip conductor portion 18) different from each other.

The pattern of the slit 17 is not limited to the rectangular shape as described above. The shape may be any shape such as a long thin elliptical shape. Any shape may be adopted as long as the current does not deviate to generate a large current at both ends in the width direction of the conductor.

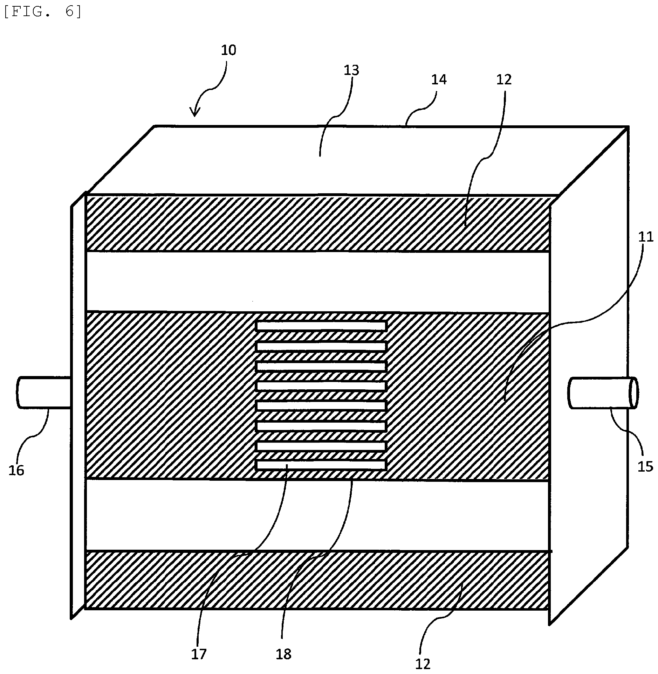

FIG. 6 is a diagram showing a second configuration example of the probe according to the embodiment of the invention. As compared with the probe in the first configuration example, the probe 10 in the second configuration example has a structure in which the transmission line body 14 constitutes a coplanar line, and includes the strip-shaped strip conductor 11 formed on the front surface of the dielectric substrate 13 and two ground conductors 12 arranged on both sides of the strip conductor 11 with an interval therebetween. The probe 10 includes the transmission line body 14 constituting the coplanar line, and the connectors 15 and 16 electrically connected to both ends of the transmission line body 14 in the length direction, respectively. A pattern of the strip conductor 11 of the transmission line body 14 may be the same pattern as the pattern shown in FIG. 3 or FIG. 5. The transmission line body 14 is not limited to the exemplified microstrip line or the coplanar line, but may be other transmission line structures.

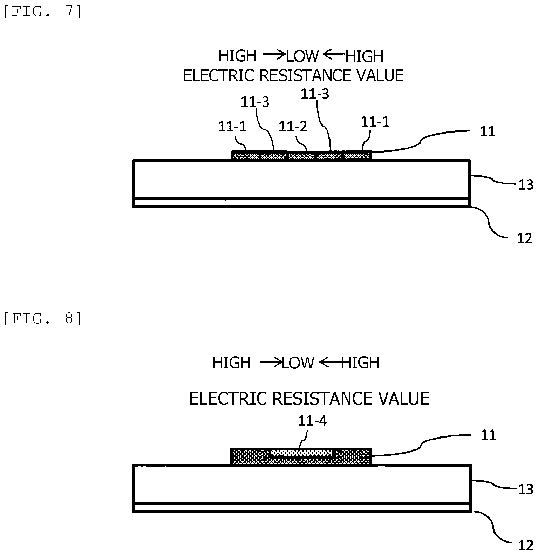

Next, a configuration example of a probe according to a second embodiment of the invention will be described. FIG. 7 is a diagram showing a pattern of a strip conductor constituting the probe according to the second embodiment of the invention.

A difference thereof with the probe 10 according to the first embodiment is that in the third length portion of the strip conductor 11, instead of providing the slit 17 or in addition to the slit 17, the current deviation prevention unit is constituted by conductors made of a plurality of materials with different electric resistance values.

In this case, in order to prevent a current from being deviated to both ends in the width direction of the conductor to generate a large current, the strip conductor 11 is constituted by a conductor 11-1 made of a material having a high electric resistance value at both ends in the width direction, and the strip conductor 11 is constituted by a conductor 11-2 made of a material having a low electric resistance value at the center portion. The number of the materials of the conductor may be two or more, and a conductor having the same material as that used for the first length portion and the second length portion may be used as one of the materials. In the example of FIG. 7, the number of the materials of the conductor is three, and a conductor 11-3 made of a material having an intermediate electric resistance value is disposed between the conductor 11-1 made of a material having a high electric resistance value and the conductor 11-2 made of a material having a low electric resistance value.

The strips of different materials may be in close contact with each other, or may be separated from each other in the form of providing slits as in the first embodiment.

In this way, by using the conductors made of a plurality of materials having different electric resistance values, large currents are not deviated to both ends in the width direction of a wide width portion of the strip conductor, and therefore, even samples with a large area can be measured with high accuracy.

Next, a configuration example of a probe according to a third embodiment of the invention will be described. FIG. 8 is a diagram showing a pattern of a strip conductor constituting the probe according to the third embodiment of the invention.

A difference thereof with the probe 10 according to the first embodiment is that a conductor 11-4 having a conductivity higher than the conductivity of the strip conductor is laminated on a center portion of the strip conductor on the third length portion of the strip conductor 11 instead of the slit 17 or in addition to the slit 17, as the current deviation prevention unit.

As shown in FIG. 8, when the conductor 11-4 having a high conductivity is laminated on the strip conductor, an upper surface of the strip conductor after the lamination is preferably formed to be flat. (The original strip conductor is formed so that the center portion is thin. Alternatively, after forming the strip conductor, the center portion is removed, or the like.) This is because the magnetic material 1 to be measured is often flat, and under this case, if the strip conductor is not horizontal, it becomes difficult to place the object to be measured horizontally. However, depending on the sample to be measured, the sample may be laminated on the strip conductor as it is.

Since the conductor 11-4 having a conductivity higher than the conductivity of the strip conductor is provided in the center portion of the strip conductor, the current is not deviated to both ends in the width direction of the conductor to generate a large current.

A plurality of conductors having higher conductivity may be laminated toward the center of the conductor 11-4 having a high conductivity.

Here, an example in which the conductor 11-4 having a conductivity higher than the conductivity of the strip conductor 11 is applied to the center portion of the strip conductor 11 is described, but the same effect can be obtained by providing a conductor having a conductivity lower than the conductivity of the strip conductor at both ends of the strip conductor 11 in the width direction.

Note that any known methods may be used as a method for providing the conductor 11-4 having a high conductivity, and any method may be used such as applying a silver paste or the like, forming by sputtering, and precipitation by electrodeposition.

In this way, by providing a conductor having a different conductivity on the strip conductor, large currents are not deviated to both ends in the width direction of the wide width portion of the strip conductor, and therefore, even samples with a large area can be measured with high accuracy.

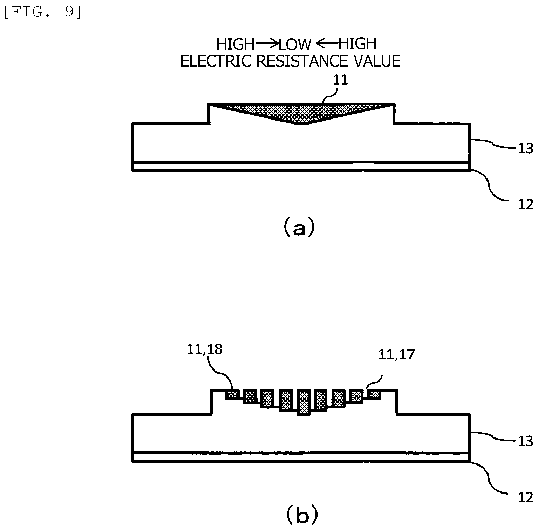

Next, a configuration example of a probe according to a fourth embodiment of the invention will be described. FIG. 9 is a diagram showing a pattern of a strip conductor constituting the probe according to the fourth embodiment of the invention.

A difference thereof with the probe 10 according to the first embodiment is that instead of the slit 17 or in addition to the slit 17, a configuration in which the film thickness of the strip conductor is made larger at the center portion and made smaller toward both ends in the width direction is provided as the current deviation prevention unit on the third length portion of the strip conductor 11. (a) of FIG. 9 shows a configuration example in which the film thickness of the strip conductor is varied without providing the slit 17, and (b) of FIG. 9 shows a configuration example in which the slit 17 is provided to make the film thickness of the strip conductor different.

As shown in (a) and (b) of FIG. 9, when the film thickness is increased, in order to make the upper surface of the strip conductor flat, it is preferable to form grooves of different depths in the dielectric substrate 13 and embed the strip conductor therein. This is because the magnetic material 1 to be measured is often flat, and in this case, if the upper surface of the strip conductor is not horizontal, it is difficult to horizontally place the target to be measured. However, depending on the sample to be measured, the film thickness on the planar dielectric substrate 13 may be increased.

Since the film thickness of the center portion of the strip conductor is large and decreases toward both ends in the width direction, the current is likely to flow to the center portion where the electric resistance is low, so that the current is not deviated to both ends in the width direction of the conductor to generate a large current.

As shown in (b) of FIG. 9, a combination of a configuration in which the slit 17 is provided and a configuration in which the film thickness of the center portion of the strip conductor is made larger than both ends thereof is more effective.

In this way, by providing a conductor having a different conductivity on the strip conductor, large currents are not deviated to both ends in the width direction of the wide width portion of the strip conductor, and therefore, even samples with a large area can be measured with high accuracy.

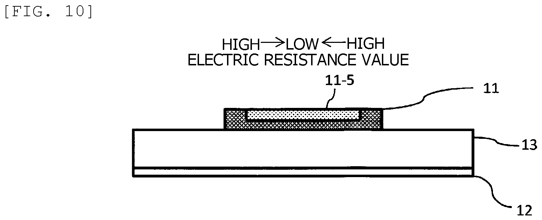

Next, a configuration example of a probe according to a fifth embodiment of the invention will be described. FIG. 10 is a diagram showing a pattern of a strip conductor constituting the probe according to the fifth embodiment of the invention.

A difference thereof with the probe 10 according to the first embodiment is that a configuration in which the center portion of the strip conductor 11 is doped with a material 11-5 that improves conductivity so that the conductivity of the center portion is improved is provided on the third length portion of the strip conductor 11 as the current deviation prevention unit.

Since the conductivity of the center portion of the strip conductor 11 is high, the current is likely to flow to the center portion where the electric resistance is low, and therefore, the current is not deviated to both ends in the width direction of the conductor to generate a large current.

The same effect can be obtained by doping the vicinity of both ends in the width direction of the conductor with the material 11-5 that reduces conductivity, thereby increasing the electric resistance at both ends in the width direction.

In this way, by performing various kinds of doping on the strip conductor, large currents are not deviated to both ends in the width direction of the wide width portion of the strip conductor, and therefore, even samples with a large area can be measured with high accuracy.

The embodiments of the invention are not limited to the above, and any embodiment is possible as long as most of the current flows to the center portion.

A measurement procedure according to the magnetic permeability measurement device including the probe 10 of the invention will be described below.

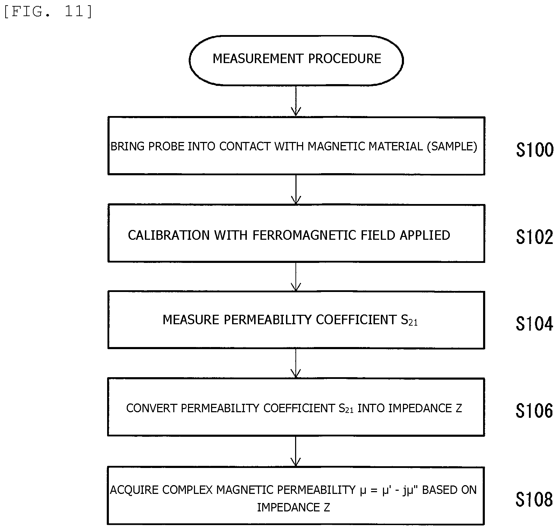

FIG. 11 is a flowchart showing a procedure of a magnetic permeability measurement method according to the embodiment of the invention. The transmission line body 14 of the probe 10 is brought into contact with the magnetic material 1 to be measured (S100). Then, a strong DC magnetic field (for example, approximately 20 kOe) is applied into a pole gap of the double yoke type electromagnet 40, and the magnetic material 1 is saturated and calibrated by the network analyzer 20 (S102). In this way, electrical lengths of the probe 10 and the coaxial cable 3, a DC impedance of the magnetic material, a nonmagnetic signal, and the like are removed. Thereafter, the DC magnetic field is removed to measure the permeability coefficient $S_{21}$ contributed by the magnetic material 1 (S104). By Equation (2) below, the permeability coefficient $S_{21}$ is converted into an impedance Z of the magnetic material 1 (S106).

[Math. 2]

$$Z = 100 \frac{1 - S_{21}}{S_{21}} \qquad (2)$$

Specifically, the permeability coefficient $S_{21}$ depending on the presence or absence of a magnetic field for saturating the magnetic material 1 is measured by the network analyzer 20. The state in which the probe 10 is brought into contact with the magnetic material 1 and the magnetic material 1 is saturated by the electromagnet is defined as a background, and the permeability coefficient under this case is used as a reference signal. Next, a permeability coefficient when the magnetic field of the electromagnet is removed is measured. The permeability coefficient under this case is a differential signal with respect to the reference signal, that is, a difference value between the permeability coefficients with and without the magnetic field, which reflects magnetic characteristics of the magnetic material 1. The difference value between the permeability coefficients is an impedance component contributed by the magnetic material 1.

According to Equation (2), the impedance Z is the difference value between the permeability coefficients, and a real part thereof is a loss (resistance component) R of the magnetic material 1 and an imaginary part thereof is an inductance component L of the magnetic material 1. The inductance component L corresponds to a real part $\mu'$ of the magnetic permeability of the magnetic material 1, and the resistance component R corresponds to the imaginary part $\mu''$ of the magnetic permeability of the magnetic material 1. Note that the magnetic permeability (complex magnetic permeability) $\mu$ of the magnetic material 1 is represented by the following Equation (3). Note that Equation (3) is the same as Equation (1) of the section of Background Art.
[Math. 3]

$$\mu = \mu' - j\mu'' \qquad (3)$$

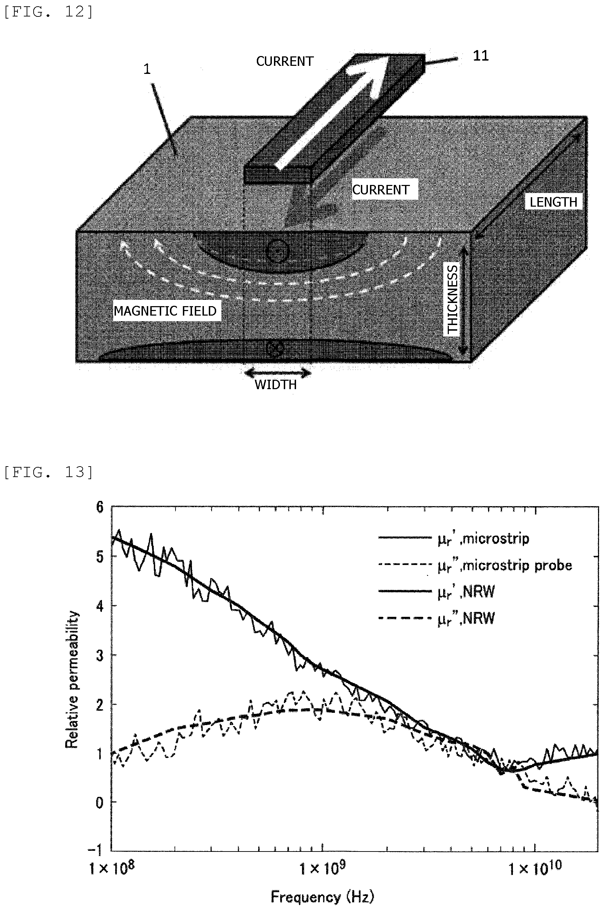

FIG. 12 is a diagram schematically showing a shape of a magnetic film as the magnetic material to be measured. As the frequency of the current flowing through the strip conductor 11 increases, the current flows only on the front surface of the magnetic material (magnetic film) 1 due to the skin effect. As shown in FIG. 12, it is assumed that the impedance Z is determined due to the current being deviated in a film thickness direction due to the skin effect, and as the numerical value analysis processing, for example, $\mu'$ and $\mu''$ are calculated iteratively by the Newton-Raphson method using the above Equation (3) and the following Equations (4) and (5), and the complex magnetic permeability is calculated by optimization processing so that a predetermined evaluation function value is minimized (S108).
[Math. 4]

$$Z = \frac{k\rho l}{2w}\coth\left(\frac{kt}{2}\right) \qquad (4)$$

[Math. 5]

$$k = \frac{1+j}{\sqrt{\dfrac{\rho}{\pi f \mu}}} \qquad (5)$$

Here, Z is an impedance, $\rho$ is a resistance, l is a sample length, w is a sample width, t is a film thickness, f is a frequency, and $\mu$ is a complex magnetic permeability.

FIG. 13 is a graph of a measurement result of the magnetic permeability measured by the magnetic permeability measurement device using the probe according to the embodiment of the invention. The sample to be measured was a NiZn ferrite film (3 mm × 1 mm × thickness 100 $\mu$m), and was compared with a measurement value according to the NRW method, which is a standard magnetic permeability measurement method without an influence of a diamagnetic field. The microstrip line shown in FIG. 2 was used for the transmission line body 14 provided with the slit 17. The measurement value of the magnetic permeability measured using the probe according to the embodiment of the invention substantially corresponds to the measurement value according to the NRW method, and results showing that the influence of the diamagnetic field can be eliminated and that both the real part $\mu'$ and the imaginary part $\mu''$ of complex magnetic permeability ($\mu = \mu' - j\mu''$) can be measured with high accuracy over the entire frequency range up to the high frequency band, were obtained.

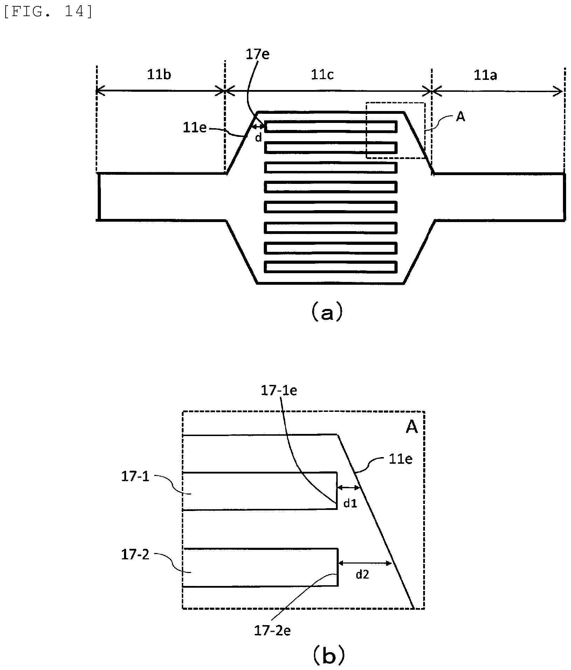

FIG. 14 is a diagram showing a modification of the strip conductor 11 constituting the probe according to the first embodiment of the invention. (a) of FIG. 14 shows a pattern of the strip conductor 11 similar to that in (a) of FIG. 5, and (b) of FIG. 14 is an enlarged view of a portion A surrounded by a dotted line in (a) of FIG. 14. In the strip conductor 11 shown in FIG. 14, the third length portion 11c has a larger width dimension in the width direction than the first length portion 11a and the second length portion 11b, and a plurality of slits 17 are provided in parallel and side by side in the third length portion 11c across the width direction thereof. Preferably, the plurality of slits 17 have the same length in the length direction.

The third length portion 11c is formed in a tapered shape in which an edge (width direction edge) 11e extending in the width direction is tapered to be narrower toward both end sides in the width direction. Accordingly, an interval d extending in the length direction from a length direction end 17e of each slit to the width direction edge 11e of the third length portion 11c is designed to decrease from the center portion in the width direction toward both end sides.

More specifically, as shown in (b) of FIG. 14, for a first slit 17-1 positioned relatively at both end sides in the width direction and a second slit 17-2 positioned at the center in the width direction relative to the first slit 17-1, a first interval d1 extending in the length direction from a length direction end 17-1e of the first slit 17-1 to the width direction edge 11e of the third length portion 11c is designed to be shorter than a second interval d2 extending in the length direction from a length direction end 17-2e of the second slit 17-2 to the width direction edge 11e of the third length portion 11c. By making the interval d smaller toward both end sides in the width direction of the strip conductor 11, and making a flow path of the current flowing through the strip conductor 11 narrower toward both end sides, the electric resistance at both end sides is increased, the deviation of the current flowing at both end sides is prevented, and a more uniform current can flow throughout the entire strip conductor 11.

Note that the narrowest interval d (first interval d1) is preferably as small as possible, but due to constraints on design and manufacturing precision of microfabrication techniques, it is preferable to set the interval to, for example, approximately 2 μm to 10 μm.

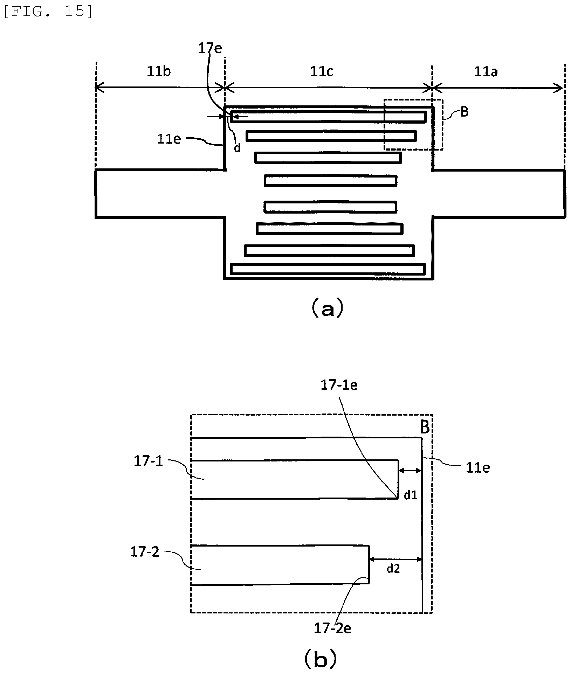

FIG. 15 is a diagram showing the other modification of the strip conductor 11 constituting the probe according to the first embodiment of the invention. (a) of FIG. 15 shows a pattern of the strip conductor 11, and (b) of FIG. 15 shows an enlarged view of a portion B surrounded by a dotted line in (a) of FIG. 15. In the strip conductor 11 shown in FIG. 15, the third length portion 11c has a larger width dimension in the width direction than the first length portion 11a and the second length portion 11b, and a plurality of slits 17 are provided in parallel and side by side in the third length portion 11c across the width direction thereof. The plurality of slits 17 are designed to have different lengths in the length direction, and to be longer at both end sides in the width direction.

The third length portion 11c is formed such that the width direction edge 11e rises to form a right angle from the strip-shaped first length portion 11a and the second length portion 11b toward both end sides in the width direction, and the third length portion 11c has a rectangular shape as a whole. Accordingly, since the plurality of slits 17 have different lengths, the interval d extending in the length direction from the length direction end 17e of each slit to the width direction edge 11e of the third length portion 11c is designed to decrease from the center portion in the width direction toward both end sides, and the conductor width is designed to decrease toward the ends, thereby eliminating the skin effect at the ends.

More specifically, in (b) of FIG. 15, similarly to (b) of FIG. 14, for the first slit 17-1 positioned relatively at both end sides in the width direction and the second slit 17-2 positioned at the center in the width direction relative to the first slit 17-1, the first interval d1 extending in the length direction from the length direction end 17-1e of the first slit 17-1 to the width direction edge 11e of the third length portion 11c is designed to be shorter than the second interval d2 extending in the length direction from the length direction end 17-2e of the second slit 17-2 to the width direction edge 11e of the third length portion 11c. By making the interval d smaller toward both end sides in the width direction of the strip conductor 11, and making a flow path of the current flowing through the strip conductor 11 narrower toward both end sides, the electric resistance at both end sides is increased, the deviation of the current flowing at both end sides is prevented, and a more uniform current can flow throughout the entire strip conductor 11. Note that in the example shown in FIG. 15, preferably, the positions and widths of the slits may be adjusted so that the conductor width (the width between the slits and the conductor width on the outermost side) is narrowed from the center portion toward both end portions in order to make it difficult for the current to flow to both end sides.

In the modifications of FIGS. 14 and 15, the effect also can be further enhanced by combining with the configuration shown in (b) of FIG. 5 in which the intervals between the slits 17 are different at the center and at both end sides or the configuration shown in (c) of FIG. 5 in which the width dimensions s of the slits 17 are different at the center and at both end sides in the width direction. In addition to the slits, the effect may also be enhanced by combining the configuration in which the film thickness at the center which is made larger is different from that at both end sides as shown in (a) and (b) of FIG. 9, or the configuration in which the conductivity is made different at the center and both end sides as shown in FIG. 10, with the modifications in FIGS. 14 and 15.

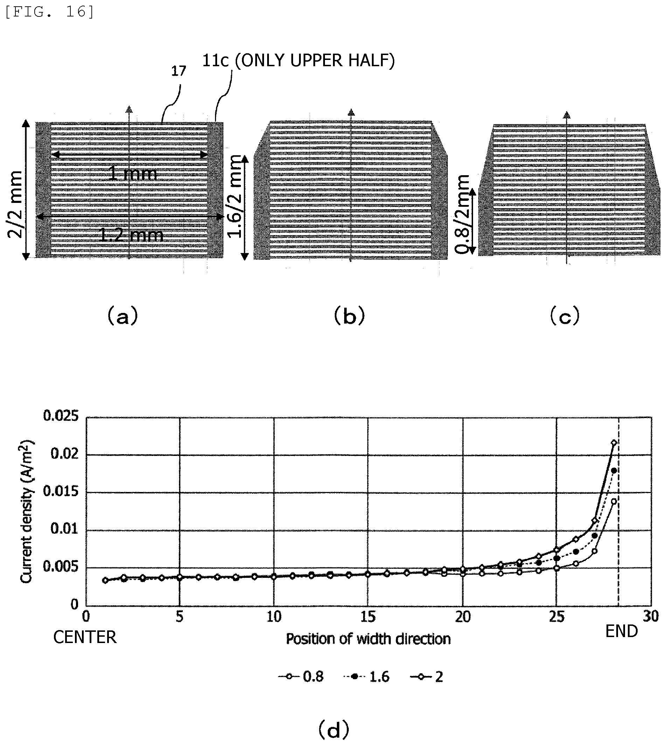

FIG. 16 is a diagram showing a measurement result of a current density flowing through the strip conductor 11, and the current density at each position in the width direction in the three shape patterns of the third length portion 11c (only the upper half shape) of the strip conductor 11 shown in (a), (b) and (c) of FIG. 16 is shown in (d) of FIG. 16. The three shape patterns shown in (a), (b) and (c) of FIG. 16 are common in that the length of the third length portion 11c is 1.2 mm, the length of the slit 17 is 1 mm, and the width direction length (only the upper half) is 2 mm, in which (a) of FIG. 16 shows a pattern in which no tapered portion is provided at the width direction edge 11e, (b) of FIG. 16 shows a pattern in which a tapered portion is formed from a position 1.6 mm up on the width direction edge 11e, and (c) of FIG. 16 shows a pattern in which a tapered portion is formed from a position 0.8 mm up thereon. Then, as shown in the graph in (d) of FIG. 16, it was clear that when the tapered portion is provided and the longer the tapered portion is, that is, the smaller the interval d is from the center portion to both end sides in the width direction, the smaller the current density at the ends becomes, so that the deviation (concentration) of the current to the ends in the width direction is prevented and it is effective to make the current density more uniform.

The invention is not limited to the above-described embodiments, and it goes without saying that the invention includes design changes, including various modifications and alterations that would be conceived of by a person skilled in the art, that do not deviate from the gist of the invention.

REFERENCE SIGNS LIST

1: magnetic material
3: coaxial cable
10: probe
11: strip conductor
12: ground conductor
13: dielectric substrate
14: transmission line body
15: connector
16: connector
17: slit (current deviation prevention unit)
18: elongated strip conductor portion
20: network analyzer (signal meter)
30: arithmetic processing device
40: double yoke type electromagnet

**Claims**

1. A probe for measuring a magnetic permeability of a magnetic material, the probe comprising:

   a transmission line body including a strip-shaped strip conductor formed on a front surface of a dielectric substrate and a ground conductor formed on the front surface or a back surface of the dielectric substrate;
   a first connector connected to one end of each of the strip conductor and the ground conductor; and
   a second connector connected to the other end of each of the strip conductor and the ground conductor, wherein
   the strip conductor includes a first length portion including a portion connected to the first connector on one end side, a second length portion including a portion connected to the second connector at the other end, and a third length portion extending between the first length portion and the second length portion, and the third length portion includes a current deviation prevention unit.

2. The probe according to claim 1, wherein the transmission line body is a microstrip line or a coplanar line.

3. The probe according to claim 1, wherein the current deviation prevention unit includes at least one slit extending in a length direction of the strip conductor.

4. The probe according to claim 3, wherein the slit includes a plurality of slits parallel to each other and extending in the length direction of the strip conductor.

5. The probe according to claim 4, wherein the plurality of slits are arranged at an equal interval in a width direction.

6. The probe according to claim 4, wherein the plurality of slits are arranged at different intervals in a width direction.

7. The probe according to claim 6, wherein the plurality of slits are arranged such that the intervals increase from both end sides toward a center portion in the width direction.

8. The probe according to claim 7, wherein the strip conductor is formed such that the center portion has a larger film thickness than the both ends in the width direction.

9. The probe according to claim 4, wherein the plurality of slits are formed with a same width dimension.

10. The probe according to claim 4, wherein the plurality of slits are formed with different width dimensions.

11. The probe according to claim 10, wherein the plurality of slits are formed and arranged such that the width dimensions thereof increase from both end sides toward a center portion in the width direction.

12. The probe according to claim 4, wherein

    the third length portion has a larger width dimension in a width direction than the first length portion and the second length portion,
    the plurality of slits includes a first slit on relatively both end sides in the width direction and a second slit on a center side in the width direction relative to the first slit, and
    a first interval extending in the length direction from a length direction end of the first slit to a width direction edge of the third length portion is shorter than a second interval extending in the length direction from a length direction end of the second slit to the width direction edge of the third length portion.

13. The probe according to claim 12, wherein

    the first slit and the second slit have a same length, and
    the width direction edge of the third length portion is formed in a tapered shape, and a length dimension of the third length portion decreases from the center side toward both end sides in the width direction.

14. The probe according to claim 12, wherein

   a length dimension of the third length portion is same from the center side toward both end sides in the width direction, and
   a length dimension of the first slit is longer than a length dimension of the second slit.

15. The probe according to claim 1, wherein the current deviation prevention unit is configured to reduce an electric resistance from an end to an inner side in a width direction of the third length portion perpendicular to a length direction of the strip conductor.

16. The probe according to claim 15, wherein in the current deviation prevention unit, the strip conductor is made of a plurality of materials having different electric resistances.

17. The probe according to claim 15, wherein in the current deviation prevention unit, a material having a conductivity different from a conductivity of the strip conductor is provided on the strip conductor.

18. The probe according to claim 15, wherein in the current deviation prevention unit, a film thickness of the strip conductor is larger on the inner side than on the end.

19. The probe according to claim 15, wherein the current deviation prevention unit is doped with a substance that changes a conductivity of the strip conductor.

20. A magnetic permeability measurement device, comprising:

   the probe according to any one of claims 1 to 19;
   a magnetic field application unit configured to apply a magnetic field to the magnetic material;
   a signal meter connected to the probe via a cable, and configured to measure a permeability coefficient signal both with and without application of the magnetic field by the magnetic field application unit; and
   a processing unit configured to acquire a magnetic permeability of the magnetic material by numerical value analysis calculation processing based on the permeability coefficient signal measured by the signal meter.

[FIG. 1]

[FIG. 2]

[FIG. 3]

[FIG. 4]

[FIG. 5]

(a)

(b)

(c)

[FIG. 6]

[FIG. 7]

HIGH —→LOW ←—HIGH
ELECTRIC RESISTANCE VALUE

11-3

11-3

11-1    11-2    11-1    11

13

12

[FIG. 8]

HIGH —→LOW ←—HIGH

ELECTRIC RESISTANCE VALUE

11-4

11

13

12

[FIG. 9]

HIGH→LOW←HIGH
ELECTRIC RESISTANCE VALUE

(a)

(b)

[FIG. 10]

HIGH→LOW←HIGH
ELECTRIC RESISTANCE VALUE

11-5

11

13

12

[FIG. 11]

MEASUREMENT PROCEDURE

BRING PROBE INTO CONTACT WITH MAGNETIC MATERIAL (SAMPLE)     S100

CALIBRATION WITH FERROMAGNETIC FIELD APPLIED     S102

MEASURE PERMEABILITY COEFFICIENT $S_{21}$     S104

CONVERT PERMEABILITY COEFFICIENT $S_{21}$ INTO IMPEDANCE Z     S106

ACQUIRE COMPLEX MAGNETIC PERMEABILITY $\mu = \mu' - j\mu''$ BASED ON IMPEDANCE Z     S108

[FIG. 12]

[FIG. 13]

[FIG. 14]

(a)

(b)

[FIG. 15]

（a）

（b）

[FIG. 16]

11c (ONLY UPPER HALF)

17

2/2 mm
1 mm
1.2 mm

(a)

1.6/2 mm

(b)

0.8/2mm

(c)

(d)

[FIG. 17]

[FIG. 18]

(a)

(b)

## INTERNATIONAL SEARCH REPORT

| International application No. |
|---|
| **PCT/JP2023/019074** |

**A. CLASSIFICATION OF SUBJECT MATTER**

*G01R 33/12*(2006.01)i

FI: G01R33/12 Z

According to International Patent Classification (IPC) or to both national classification and IPC

**B. FIELDS SEARCHED**

Minimum documentation searched (classification system followed by classification symbols)

G01R33/12

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2021-162413 A (TOHOKU UNIVERSITY) 11 October 2021 (2021-10-11)<br>entire text, all drawings | 1-20 |
| A | JP 2021-162327 A (TOHOKU UNIVERSITY) 11 October 2021 (2021-10-11)<br>entire text, all drawings | 1-20 |
| A | JP 2016-53569 A (GAKKOU HOUJIN TOUHOKU GAKUIN) 14 April 2016 (2016-04-14)<br>entire text, all drawings | 1-20 |
| A | JP 2012-32165 A (YABUKAMI, Shin) 16 February 2012 (2012-02-16)<br>entire text, all drawings | 1-20 |
| A | CN 109884565 A (BEIJING UNIVERSITY OF TECHNOLOGY) 14 June 2019 (2019-06-14)<br>entire text, all drawings | 1-20 |
| A | CN 106443198 A (INSTITUTE OF DONGGUAN-TONGJI UNIVERISTY) 22 February 2017 (2017-02-22)<br>entire text, all drawings | 1-20 |

☑ Further documents are listed in the continuation of Box C.   ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **31 July 2023** | **15 August 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

28

## INTERNATIONAL SEARCH REPORT

| | International application No. |
|---|---|
| | **PCT/JP2023/019074** |

**C.      DOCUMENTS CONSIDERED TO BE RELEVANT**

| Category* | Citation of document, with indication, where appropriate, of the relevant passages | Relevant to claim No. |
|---|---|---|
| A | WO 2016/156885 A1 (OXFORD UNIVERSITY INNOVATION LTD.) 06 October 2016 (2016-10-06)<br>    p. 8, lines 23, 24, fig. 27, 28 | 1-20 |
| A | JP 2005-274381 A (TOHOKU TECHNO ARCH CO., LTD.) 06 October 2005 (2005-10-06)<br>    paragraphs [0006]-[0012] | 1-20 |

Form PCT/ISA/210 (second sheet) (January 2015)

### INTERNATIONAL SEARCH REPORT
**Information on patent family members**

International application No.

**PCT/JP2023/019074**

| Patent document cited in search report | | | Publication date (day/month/year) | Patent family member(s) | Publication date (day/month/year) |
|---|---|---|---|---|---|
| JP | 2021-162413 | A | 11 October 2021 | (Family: none) | |
| JP | 2021-162327 | A | 11 October 2021 | (Family: none) | |
| JP | 2016-53569 | A | 14 April 2016 | (Family: none) | |
| JP | 2012-32165 | A | 16 February 2012 | (Family: none) | |
| CN | 109884565 | A | 14 June 2019 | (Family: none) | |
| CN | 106443198 | A | 22 February 2017 | (Family: none) | |
| WO | 2016/156885 | A1 | 06 October 2016 | (Family: none) | |
| JP | 2005-274381 | A | 06 October 2005 | US 2005/0212514 A1 paragraphs [0009]-[0013] | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2010060367 A
- JP 2012032165 A
- JP 2015172497 A
- JP 2016053569 A